(19) Europäisches Patentamt
European Patent Office
Office européen des brevets

(11) Publication number: 0 422 628 A2

(12) # EUROPEAN PATENT APPLICATION

(21) Application number: 90119460.5

(22) Date of filing: 11.10.90

(51) Int. Cl.5: G03F 7/039

(30) Priority: 13.10.89 US 421546

(43) Date of publication of application:
17.04.91 Bulletin 91/16

(84) Designated Contracting States:
DE FR GB IT

(71) Applicant: E.I. DU PONT DE NEMOURS AND COMPANY
1007 Market Street
Wilmington Delaware 19898(US)

(72) Inventor: Reiser, Arnost
244 Henry Street
Brooklyn, New York 11201(US)
Inventor: Li, Min Yu
2150 Wilson Avenue, Apt. 301
St. Paul, Minnesota 55119(US)

(74) Representative: Werner, Hans-Karsten, Dr. et al
Deichmannhaus am Hauptbahnhof
W-5000 Köln 1(DE)

(54) **Photosensitive element.**

(57) A photosensitive element is provided wherein the photosensitive composition contains a polymeric compound having acid-degradable crosslinkages and a component that generates acid upon exposure to actinic radiation.

EP 0 422 628 A2

Xerox Copy Centre

# PHOTOSENSITIVE ELEMENT

## FIELD OF THE INVENTION

The invention relates to photosensitive elements for chemical imaging. More particularly, the invention relates to photosensitive elements comprising polymeric layers having acid-degradable crosslinkages.

## BACKGROUND OF THE INVENTION

Chemical imaging refers to the making of images in films or layers by the action of light, in which the realization of the final image is often accomplished by a post-exposure processing step. The term generally encompasses imaging with non-silver based materials.

Photosensitive elements that can be used in chemical imaging processes are well known in the art. These elements can be used to prepare non-relief or relief images useful as prepress proofing materials, photoresists, printing plate precursors and the like. These elements generally comprise a support that bears a photosensitive layer. The photosensitive layer comprises a polymeric binder which serves to hold the material together, a photoinitiator, and a component that is capable of reacting with the photoinitiator, after it has been activated by exposure to actinic radiation, to produce a change in the physical properties of the material. The photosensitive element is exposed to actinic radiation through an image-bearing transparency to produce either a positive or negative latent image. The differences in the properties of the exposed and unexposed areas of the photosensitive material (e.g., differences in solubility, swellability or dispersability, differences in the softening point, differences in tackiness, differences in adhesion, differences in permeability for processing solutions, etc.) are used as the basis for developing the image. Depending on the intended end use, the developed image may be visible due to color differences, relief height differences, or combinations of the two. For some uses it is not necessary that the developed image be visibly discernible.

Photopolymers are frequently selected as the photosensitive material; i.e., the change in the physical properties is accomplished by the photoinitiated polymerization of an ethylenically unsaturated monomer. Such photopolymers generally become less soluble in developer solvents after exposure to actinic radiation (photoinsolubilized) or less tacky (photodetackified) as described, for example, in "Imaging Processes and Materials - Neblette's Eighth Edition" edited by J. Sturge, V. Walworth and A. Shepp, Chapter 7 (Van Nostrand Reinhold, 1989). Other photosensitive systems become more soluble (photosolubilized) or more tacky (phototackified) after exposure to actinic radiation. The photosolubilization or phototackification may be due to degradation of polymeric constituents as disclosed in Limburg et al., U.S. Patent Nos. 3,915,704 and 3,917,483 and in Narang et al., U.S. Patent No. 4,663,269. The change also may be due to the formation of plasticizing compounds such as disclosed in Lee, U.S. Patent No. 4,356,252 and Abele et al., U.S. Patent No. 4,243,741.

While all of the above described systems can function in chemical imaging processes, there are certain disadvantages associated with them. Some of the systems are complex and require multiple layers. Others have poor photospeed, inadequate resolution, or undesirable background color. In some instances it is difficult to obtain positive- or negative-working systems for the intended end use.

## SUMMARY OF THE INVENTION

It has been found that considerable advantage can be gained by using photosensitive compositions in which acid-degradable groups are present as crosslinkages between backbone polymer chains. Such compositions have advantages in photospeed and increased photochemical efficiency. In addition, the backbone polymer can be chosen to have whatever physical properties are desired in the system without the need to interrupt the backbone with degradable linkages. Thus, for example, decreased oxygen or moisture permeability and increased etching resistance can be built into the photosensitive element. Such compositions are particularly advantageous for use as single-layer negative-working proofing materials and positive-working photoresists.

Accordingly, this invention provides a photo-sensitive element comprising a support that bears a

photosensitive layer, said photosensitive layer comprising

(a) a polymeric compound having acid-degradable crosslinkages present in the amount of at least approximately 1% by weight, based on the weight of the polymer, and

(b) a photosensitive component that generates acid upon exposure to actinic radiation.

The invention also provides a process for forming a negative image comprising the steps of:

(a) forming on a substrate a photosensitive layer containing a polymeric compound with acid-degradable crosslinkages and a photosensitive compound that generates acid upon exposure to actinic radiation,

(b) imagewise exposing the photosensitive layer to actinic radiation, and

(c) applying particulate material that selectively adheres to the exposed areas of the photosensitive layer.

## DETAILED DESCRIPTION OF THE INVENTION

The present invention provides a versatile photosensitive element comprising a photosensitive layer on a support. The photosensitive layer comprises a polymeric material that is crosslinked with acid-degradable crosslinkages and a photosensitive compound which generates acid upon exposure to actinic radiation. Thus, exposure to actinic radiation results in the generation of acid which catalyzes the breakdown of the crosslinking groups. This decoupling of the polymer units lowers the $T_g$ of the material in the areas exposed to radiation, causing an increase in solubility, swellability, or dispersability and/or an increase in tackiness. The exposed element can then be developed by washing out the exposed areas with developer solvents, or developed by the application of particulate toner material which selectively adheres to the exposed areas.

The polymeric backbone, acid-degradable crosslink groups and crosslink density are selected to meet the needs of the intended end use. It is important in all cases, however, that the photoinitiated reaction and the resulting scission of the crosslinks cause sufficient change in the $T_g$ of the material to permit development. Thus, the partially or fully decrosslinked material must increase in solubility or swellability in developer solvents, or increase in tackiness to the extent that particulate toner material will preferentially adhere to the exposed regions of the photosensitive element.

Conventional thermoplastic polymers can generally be used as the polymer backbone, although other types of polymers may be selected for specific applications. Polymers that may be selected include acrylic acid or methacrylic acid ester polymers and/or their copolymers with other suitable monomers (e.g., acrylic or methacrylic acids or esters or other acryl or vinyl monomeric compounds); copolymers of maleic acid anhydride, or their di- or half esters with styrene or other vinyl monomers; chlorine-containing vinyl polymers or copolymers (e.g., polyvinyl chloride including post chlorination products, polyvinylidene chloride, chlorinated polyethylene, etc.); polystyrene and polystyrene copolymers; ethylene and ethylene copolymers (e.g., with maleic acid, etc.); synthetic types of rubber (e.g. butadiene, chloroprene and their copolymers, e.g., with styrene, acrylonitrile, etc.); and polyethers, (e.g., polyepichlorohydrin, etc.). Preferred polymers are those of acrylic or methacrylic acids or their esters.

The crosslinking agent is generally a monomer having at least one acid-degradable linkage and two or more terminal ethylenic groups capable of copolymerization with the backbone monomer to form the crosslinked polymer. The acid-degradable linkage in the crosslinking agent may be any thermally stable group that dissociates in the presence of the acid formed by the selected photosensitive component upon exposure to actinic radiation. Examples of such linkage groups include acid esters, carbonates, acetals, ketals, and the like. Preferred acid-degradable linkages are acid esters and carbonates. Most preferred are carboxylic acid esters. In order to prevent the reforming of the linkages after they have opened up, it is generally desirable for the linkages to be sterically hindered. A preferred crosslinking agent is the diacrylate or dimethacrylate ester of a hindered diol. The length of the diol chain is not particularly critical, but in general will be from 4 to 20 carbon atoms.

The amount of crosslinking agent is important in determining the differences in tackiness or solubility between the unexposed (crosslinked) and exposed (uncrosslinked) materials. For photosensitive elements that are to be developed by the application of particulate toner, a difference of 20 to 25°C in the $T_g$ of the crosslinked and uncrosslinked polymeric material is necessary in order to achieve adequate toning. With this difference in $T_g$ the exposed areas will retain toner while the unexposed areas will effectively remain clean. The amount of crosslinking agent necessary to produce a $T_g$ difference of this magnitude will vary with the nature of the polymer backbone. However, in general, about 5 to 35% by weight crosslinker is necessary, and, more preferably, 15 to 25%.

When the photosensitive element is to be used as a photoresist, the amount of crosslinking agent used is important in determining the photosensitivity and speed. Both decrease with increasing crosslinking

density. The exact amount of crosslinking necessary may also depend on the type of developer solvent used. In general, the amount of crosslinking agent used should be no more than 20% by weight based on the weight of the backbone polymer. For aqueous alkaline developable material the amount of crosslinking agent should be from 10-20% by weight. For solvent developable material, the amount of crosslinking agent should be less than 10% by weight and, more preferably, between 1 and 4% by weight.

To form the crosslinked polymeric compound, monomer forming the polymer backbone may be copolymerized with monomer containing the acid-degradable crosslinkages, or the polymer backbone may be formed first and then reacted with the monomer containing the crosslinkages. In the latter case, the crosslinking may be accomplished in situ after the composition has been cast to form a film. The choice of method will depend on the specific monomers selected.

The photosensitive component that is selected in the practice of the invention is any compound, or system of compounds, that generates strong acid upon exposure to actinic radiation. Examples of compounds and mixtures which can be used include diazonium, phosphonium, sulfonium and iodonium salts; halogen compounds; o-quinone diazide sulfochlorides; organo-metal/organohalogen combinations; benzoin and nitrobenzyl esters of strong acid, e.g., toluene sulfonic acid; and N-hydroxy amide and imide sulfonates as disclosed in U.S. Patent No. 4,371,605. Preferred photosensitive compounds are the unsubstituted and symmetrically or unsymmetrically substituted diaryliodonium or triarylsulfonium salts. These are generally present in the form of salts with complex metal halide anions such as tetrafluoroborate, hexafluoroantimonate, hexafluoroarsenate, and hexafluorophosphate. The amount of photosensitive compound that is used can vary from 1 to 100% by weight based on the weight of the polymer. The more reactive the linkage, the less photoinitiator is required to achieve acceptable performance. For most systems, photoinitiator in an amount of from 5 to 40% by weight will be sufficient.

It is recognized that some photoinitiators have maximum spectral sensitivity at a wavelength that is not convenient for readily available exposure sources. Therefore, it may be desirable to add sensitizers to the system to adjust spectral sensitivity to the available wavelength of actinic radiation. The need for this will depend upon the requirements of the system and the specific photosensitive compound used. For example, the iodonium and sulfonium salts respond to wavelengths below 300 nm. It is know that these salts may be sensitized to higher wavelengths using polynuclear aromatic hydrocarbons such as perylene, pyrene and anthracene.

It may be desirable to add a plasticizer to the photosensitive system. The plasticizer lowers the $T_g$ of both the crosslinked and uncrosslinked polymers. The amount of plasticizer added will depend upon the particular system, but in general from 1 to about 50% by weight based on the weight of the polymer may be added. It is important, however, that the amount of plasticizer be kept low enough that the crosslinked polymer does not become tacky or soluble in developer solvents prior to exposure to actinic radiation. Examples of plasticizers which can be used include, among others, the conventional diesters of phthalic acid, sebacic acid, adipic acid and caproic acid; alkyl phosphates such as tricresyl phosphate; glycerol esters, such as glycerol triacetate; derivatives of polyethylene glycols, such as triethylene glycol dicaprylate; and polyhydroxyethylene glycol ethers, such as polyhydroxyethylene lauryl ether. Dialkyl phthalates are generally preferred.

Aside from the already-mentioned components, the photosensitive layer may contain further additives, such as fillers, thermal stabilizers, UV absorbers, optical brighteners, antioxidants, antihalation agents, casting aids or others. In addition, the photosensitive layer may contain a binder or mixture of binders. Suitable binders would be any compatible polymeric material which does not alter the relative $T_g$'s of the crosslinked and uncrosslinked polymeric backbone in such a way as to adversely affect development by toning or washout. The above-described polymers that may be used as the polymeric backbone also may be used as an additional binder.

The support can be any material which supplies dimensional stability to the photosensitive element provided there is adequate adhesion between the photosensitive layer and the support. Examples of suitable support materials include plastic, metal, ceramic, and glass supports, as well as film supports of synthetic resin films, such as polyethylene, polypropylene, polycarbonate, polyamide, polyvinyl chloride, polyester and the like.

The photosensitive element also can have a cover layer and/or a release layer. A cover layer usually is included to prevent damage to the photosensitive layer during storage, and generally is a thin, tough thermoplastic film such as polyolefin or polyester. A release layer, such as a silicone, or a release treatment, such as exposure to electric discharge, may be used to facilitate removal of the cover layer prior to exposure and development of the photosensitive element.

Typically, the photosensitive layer will have a thickness of between 0.1 um and 1.5 mm although thicker layers may be used if desired. The thickness chosen generally will depend upon the intended end use.

Support layers are typically 0.5 to 5 mil in thickness, although this, too, will vary with the intended end use and thicker or thinner supports can be used as desired.

The photosensitive layer may be applied to the support from solvent solutions using conventional coating techniques. Such techniques include bar coating, roll coating, spraying, dipping and the like and are well known in the art. If the backbone polymer is to be crosslinked in situ, the crosslinking agent is added to the polymeric solution just prior to coating. Alternatively, the backbone polymer may be crosslinked during polymerization and the crosslinked polymer dissolved in solvent and coated as described above.

The crosslinked material, however, may be insoluble in conventional solvents, making it difficult to obtain smooth hard films. In this event excellent films can be obtained by the use of the following technique in conjunction with emulsion polymerization. Using this technique the monomers for the backbone polymer are emulsion polymerized in the presence of the crosslinking agent using standard emulsifiers and radical initiators. The reaction is controlled with carefully chosen quantities of chain transfer agents. Emulsifying agents, radical initiators and chain transfer agents that can be used in emulsion polymerization are well known in the art and have been disclosed in, for example, U.S. Patent Nos. 3,895,082 and 4,726,877.

The resulting crosslinked polymer is then isolated using any technique familiar to synthetic chemists. Typically, the polymer is isolated by first precipitating it by the addition of a non-solvent liquid and then collecting it by filtration. In general, it is preferred to purify the crosslinked polymer at this point. This is accomplished using techniques familiar to synthetic chemists. Typically, the polymer will be dispersed in a suitable carrier or solvent and reprecipitated as described above.

The choice of medium for dispersing the crosslinked polymer prior to coating is important. The medium should be a strong solvent for the non-crosslinked polymer backbone. That is, the medium should dissolve or have a solubility parameter similar to that of the non-crosslinked polymer.

Prior to coating, it is preferred that the dispersed crosslinked polymer composition be filtered. The filter size is typically 0.1 to 1.0 um. The other components of the photosensitive layer are then added to the dispersion and it is coated onto the support as described above.

The films obtained by this process are uniform, glossy, clear and completely non-tacky. They are not redispersible after drying. In this fashion, highly light sensitive films of excellent surface quality can be prepared.

The photosensitive elements of the invention are generally exposed to actinic radiation through an image-bearing transparency (usually a negative) and then developed. It is generally desirable for the photosensitive materials to possess maximum spectral sensitivity in the ultraviolet region, preferably in the wavelength region between 250 and 450 nm. Examples of suitable radiation sources for these wavelengths include sunlight, xenon lamps, mercury vapor lamps, carbon-arcs, lasers, fluorescent lamps with fluorescent materials emitting UV radiation, and electronic flash devices. It will be recognized that if the spectral sensitivity of the photosensitive system is shifted to other wavelength regions, alternative radiation sources will be used. The time of exposure will depend on the system used and may range anywhere from a few seconds up to several minutes.

Following this step, it may be necessary to have a post-exposure bake step to accelerate acid catalyzed degradation of the crosslinkages in the exposed areas. The time required for the post-exposure bake is not particularly critical and is ususally from about 1 to 10 minutes. The temperature used is generally from about 50 ° C to 120 ° C.

The exposed element is then developed. Development is accomplished by the application of particulate toner material (toning), which selectively adheres to the exposed and tackified areas of the element. Alternatively, the element may be developed by washing out the exposed areas of the element with a suitable solvent. For toning applications, toners consisting of finely-divided powders of the most varied compositions can be used. Examples are inorganic or organic pigments, fluorescent materials, metal powders, or soluble organic dyes in pure form or together with powdered organic or inorganic supports, such as titanium dioxide, silica, glass powder, carbon (carbon black or graphite), metal phthalocyanines, azo dyes, metal powders of aluminum, copper, iron, gold or silver or metal oxides. The toners may also contain additives such as wetting agents, antistatics, inert polymers, etc. For proofing applications the toners are generally colored. For full color proofs the toner colors usually correspond to the four color separations, yellow, magenta, cyan and black.

Application of the toner to the exposed areas of the film can take place either manually, for example, with the use of a pillow of various materials, such as gauze, or with the use of special, automatic applying devices. Suitable methods are known to those skilled in the field. After application of the toner, excess material is removed physically from the non-tacky unexposed portions of the film by brushing or wiping.

It will be recognized by those skilled in the art that the photosensitive layer may be transferred, usually by lamination, to different image-receiving materials or receptors prior to exposure and development. It will

also be recognized that multi-color images may be prepared by laminating together in register single color elements.

The photosensitive compositions of the invention may also be developed by solvent washout of exposed areas for either proofing or photoresist applications. This may be accomplished by immersing the element in the solvent with or without the use of brushes, spraying, or other well known wash out techniques. The solvent used will depend upon the nature of the polymeric material used in the photosensitive element and may be aqueous, non-aqueous or semi-aqueous.

It will be appreciated that the photosensitive element is not desensitized, or "fixed", following imaging. While the element normally will not be unduly sensitive to ambient radiation (e.g., room light), it may be necessary with some combinations of polymeric compounds and photoinitiator systems to take steps that avoid undesired further development. In applications where the image is developed with toner, this is conveniently accomplished by applying a coversheet over the developed element, which prevents further development of regions of the element that may become tacky due to ambient radiation.

The invention is further illustrated, but not limited, by the following examples.

## EXAMPLES

### Example 1

This example illustrates the preparation of the crosslinking agent shown below:

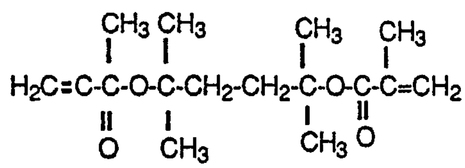

To a mixture of 25 ml anhydrous ether and 10 ml (0.07 mole) of dried triethyl amine was added 4.52 g (0.03 mole) of 2,5-dimethyl-2,5-hexanediol (97%). The mixture was stirred vigorously at 0 °C under a nitrogen atmosphere while 6.5 ml (0.066 mole) of methacryloyl chloride, which had been purified by distillation, was added dropwise. After the addition, the reaction mixture was stirred for an additional 10 hours at room temperature. After reaction, the precipitates were collected by filtration. The liquid organic mixture was washed with a 1.5% aqueous solution of $NaHCO_3$, a saturated aqueous solution of NaCl, and large amounts of water. After drying over $MgSO_4$, the solvent, ether, was removed by evaporation. The crude product was purified by chromatography using $CH_2Cl_2$ as a developer. A pure, clear liquid was obtained with a yield of 93%.

### Example 2

This example illustrates the preparation of a negative-working photosensitive element.

The following ingredients were mixed together:

| Ingredient | Amount (g) |
|---|---|
| water | 15 |
| sodium lauryl sulfate | 0.150 |
| butyl methacrylate | 3.0 |
| 1-dodecanethiol | 0.60 |
| crosslinking agent (Example 1) | 0.60 |

This solution was bubbled with nitrogen for 30 minutes and then 0.0240 g ammonium persulfate initiator

was added. The mixture was heated to 40-45 °C and kept at that temperature for three hours under nitrogen atmosphere with stirring. After polymerization, the latex was poured into a large amount of methanol and the polymer was precipitated. Purification was achieved by dispersing the polymer in acetone and reprecipitating with water. The isolated polymer was finally washed with methanol and dried overnight at 50 °C in a vacuum oven.

The dried crosslinked polymer was dispersed in ethyl acetate in the ratio of 0.005 g of polymer per ml of solvent. To this was added 10% by weight (based on the weight of the polymer) triphenylsulfonium hexafluoroantimonate and 25% by weight (based on the weight of the polymer) dioctyl phthalate. The dispersion was filtered through a 0.45 um filter and then coated onto a glass slide. The film was dried at room temperature in a steady air current and baked to 90 °C for 30 minutes.

## Example 3

This example illustrates the preparation of a toned image from the photosensitive element in Example 2 which can be used as a prepress proof.

The dried film from Example 2 was exposed through an image-bearing mask to radiation at 254 nm. The total exposure was determined to be 20 mj/cm$^2$. Following exposure the element was baked in an oven for three minutes at 90 °C. The film was then allowed to cool to room temperature. Blue particulate toner material was applied with a cotton ball and wiped over the surface of the element. Excess material was removed by wiping with a clean cotton ball. A well-defined colored negative image was obtained with a completely clean non-image area.

## Example 4

This example illustrates the preparation of a washed out image which can be used as a photoresist.

The following ingredients were mixed together:

| Ingredient | Amount (g) |
|---|---|
| water | 25 |
| sodium lauryl sulfate | 0.250 |
| butyl methacrylate | 5.0 |
| 1-dodecanethiol | 1.0 |
| crosslinking agent (Example 1) | 0.10 |

This solution was bubbled with nitrogen for 30 minutes and then 0.040 g ammonium persulfate initiator was added. The mixture was heated to 40-45 °C and kept at that temperature for three hours under nitrogen atmosphere with stirring. After polymerization, the latex was poured into a large amount of methanol and the polymer was precipitated. Purification was achieved by dispersing the polymer in acetone and reprecipitating with water. The isolated polymer was finally washed with methanol and dried overnight at 50 °C in a vacuum oven.

The dried crosslinked polymer was dispersed in ethyl acetate in the ratio of 0.5 g of polymer per ml of solvent. To this was added 10% by weight (based on the weight of the polymer) triphenylsulfonium hexafluoroantimonate. The dispersion was filtered through a 0.45 um filter and then coated onto a glass slide. The film was dried at room temperature in a steady air current and baked to 90 °C for 30 minutes.

The dried film was exposed through an image-bearing mask to radiation at 254 nm. The total exposure was determined to be 4 mj/cm$^2$. Following exposure the element was baked in an oven for three minutes at 90 °C. The film was then allowed to cool to room temperature. The exposed element was immersed in a developer solution of chloroform and carbon tetrachloride in a 1:2 ratio by volume for less than 60 seconds. The exposed areas were completely removed by the developer solvent while the unexposed areas remained on the support. In this manner a well-defined positive wash-out image was obtained.

Having described the invention, we claim the following and their equivalents:

## Claims

1. A photosensitive element comprising a support that bears a photosensitive layer, said photosensitive layer comprising
(a) a polymeric compound having acid-degradable crosslinkages present in the amount of at least approximately 1% by weight, based on the weight of the polymer and
(b) a photosensitive component that generates acid upon exposure to actinic radiation.

2. The photosensitive element of claim 1 wherein the polymer backbone is a thermoplastic polymer selected from the group consisting of acrylic or methacrylic acid ester polymers or copolymers, maleic acid anhydride copolymers with a vinyl monomer, chlorine-containing vinyl polymers or copolymers, polystyrene and polystyrene copolymers, ethylene and ethylene copolymers, synthetic rubber, and polyethers.

3. The photosensitive element of claim 2 wherein the polymer backbone is a polymer of acrylic or methacrylic acid and esters thereof.

4. The photosensitive element of claim 2 or 3 wherein the acid-degradable crosslinkages contain a group selected from the group consisting of acid esters, carbonates, acetals, and ketals.

5. The photosensitive element of claim 4 wherein acid-degradable crosslinkage is a carboxylic acid ester.

6. The photosensitive element of claim 5 wherein the carboxylic acid ester is the diacrylate or dimethacrylate ester of a sterically hindered diol.

7. A photosensitive element of claim 1 wherein the acid-degradable crosslinkage contains an acid ester or carbonate group.

8. The photosensitive element of claim 7 wherein at least a portion of the acid-degradable crosslinkages are sterically hindered carboxylic ester groups.

9. The photosensitive element of claim 7 wherein the polymeric compound has a polymeric backbone comprising an acrylic polymer.

10. The photosensitive element of claim 1 wherein the acid-degradable crosslinkages are present in an effective amount to reduce $T_g$ of the polymeric compound by approximately 20 to 25 °C upon exposure to actinic radiation.

11. The photosensitive element of claim 10 wherein the polymeric compound contains, by weight, approximately 1 to 35% monomer units having the acid-degradable crosslinkages.

12. The photosensitive element of claim 11 adapted for development with particulate toner and containing approximately 15 to 25% monomer units having the acid-degradable crosslinkages.

13. The photosensitive element of claim 11 adapted for use as a photoresist and containing approximately 1 to 20% monomer units having the acid-degradable crosslinkages.

14. The photosensitive element of claim 1 or 4 wherein the photosensitive component comprises an onium salt selected from the group consisting of halogen onium salts, onium salts of Group VA elements and onium salts of Group VIA elements having a $BF_4^-$ or $MF_6^-$ anion, where M is selected from the group consisting of P, As, and Sb.

15. The photosensitive element of claim 14 wherein the photosensitive component comprises triphenylsulfonium hexafluoroantimonate.

16. The photosensitive element of claim 14 wherein the photosensitive component comprises diphenyliodonium hexafluoroantimonate.

17. A process for forming a negative image comprising the steps of:
(a) forming on a substrate a photosensitive layer containing a polymeric compound with acid-degradable crosslinkages and a photosensitive component that generates acid upon exposure to actinic radiation,
(b) imagewise exposing the photosensitive layer to actinic radiation, and
(c) applying particulate material that selectively adheres to the exposed areas of the photsensitive layer.

18. The process of claim 17 including the step of heating the exposed photosensitive layer to a temperature of about 50 °C to about 120 °C after step (b) and before step (c).

19. The process of claim 17 or 18 wherein the acid-degradable crosslinkage comprise functional groups selected from the group consisting of carbonate groups and ester groups.

20. The process of claim 17 or 18 wherein the acid-degradable crosslinkages comprise hindered ester groups.

21. The process of claim 17 or 18 wherein the polymeric compound has a polymeric backbone comprising an acrylic polymer.

22. The process of claim 17 or 18 wherein the photosensitive compound component comprises an onium salt selected from the group consisting of halogen onium salts, onium salts of Group VA elements and onium salts of Group VIA elements having a $BF_4^-$ or $MF_6^-$ anion, where M is selected from the group consisting of P, As, and Sb.

23. The process of claim 22 wherein the photosensitive component comprises triphenylsulfonium hexafluoroantimonate.

24. The process of claim 22 wherein the photosensitive component comprises diphenyliodonium hexafluoroantimonate.

25. The process for forming a positive-working photoresist comprising the steps of:

(a) forming on a substrate a photosensitive layer containing a polymeric compound with acid-degradable crosslinkages and a photosensitive component that generates acid upon exposure to actinic radiation,

(b) imagewise exposing the photosensitive layer to actinic radiation, and

(c) washing out the exposed areas of the photosensitive layer with a developer solvent.

26. The process of claim 25 including the step of heating the exposed photosensitive layer to a temperature of about 50°C to about 120°C after step (b) and before step (c).

27. The process of claim 25 or 26 wherein the acid-degradable crosslinkage comprise functional groups selected from the group consisting of carbonate groups and ester groups.

28. The process of claim 25 or 26 wherein the acid-degradable crosslinkages comprise hindered ester groups.

29. The process of claim 25 or 26 wherein the polymeric compound has a polymeric backbone comprising an acrylic polymer.

30. The process of claim 25 or 26 wherein the photosensitive compound component comprises an onium salt selected from the group consisting of halogen onium salts, onium salts of Group VA elements and onium salts of Group VIA elements having a $BF_4^-$ or $MF_6^-$ anion, where M is selected from the group consisting of P, As, and Sb.

31. The process of claim 30 wherein the photosensitive component comprises triphenylsulfonium hexafluoroantimonate.

32. The process of claim 30 wherein the photosensitive component comprises diphenyliodonium hexafluoroantimonate.

33. A method of producing a film from a photosensitive composition comprising a polymer crosslinked with acid-degradable crosslinkages and a photosensitive components that generates acid upon exposure to actinic radiation, said method comprising:

(a) copolymerizing a monomer and a crosslinking agent in the presence of an emulsifying agent,

(b) isolating the crosslinked polymer from step (a),

(c) dispersing the isolated crosslinked polymer from step (b) in a liquid,

(d) coating the dispersed polymer composition from step (c) onto a substrate to form a film, and

(e) drying the coated crosslinked polymer film.

34. The method of claim 33 wherein the monomer is selected from the group consisting of acrylic acid, methacrylic acid, acrylic esters, methacrylic esters and mixtures thereof.

35. The method of claim 33 wherein the emulsifying agent is an anionic or nonionic surfactant.